# EUROPEAN PATENT APPLICATION

(11) **EP 4 554 352 A1**
(43) Date of publication of application: **14.05.2025**
(21) Application number: 24211823.0
(22) Date of filing: 08.11.2024
(51) Int. Cl.: H10D 30/47, H10D 62/13, H10D 64/27, H10D 62/85

(54) **III-NITRIDE TRANSISTOR WITH HIGH N DOPING IN ACCESS REGION**

(30) Priority: 13.11.2023 US 202363548315 P; 05.11.2024 US 202418937593
(71) Applicant: Finwave Semiconductor, Inc., Belmont MA 02478 (US)
(72) Inventor: Pei, Dongfei, Waban, 02468 (US); Lu, Bin, Fremont, 94555 (US); Emmer, Hal, Wayland, 01778 (US); Dipsey, Mark, Arlington, 02474 (US)
(74) Representative: Uexküll & Stolberg

(57) **Abstract**

A transistor structure for use with III-Nitride semiconductor structures is disclosed. The transistor includes heavily doped n++ layers (18) located in the source region and the drain region. The source and drain electrodes (16, 17) are disposed on their respective heavily doped n++ layer. Further, in some embodiments, a portion of the gate electrode may be disposed on one or both of the heavily doped n++ regions. These regions improve the on-resistance of the transistor, especially for low voltage applications.

## Description

This application claims priority to U.S. Provisional Patent Application Serial No. 63/548,315, filed November 13, 2023 and U.S. Patent Application Serial No. 18/937,593, filed November 5, 2024, the disclosures of which are incorporated herein by reference in their entireties.

### FIELD

Embodiments of the present disclosure relate to a transistor and methods for making a transistor with low on-resistance at low voltage applications.

### BACKGROUND

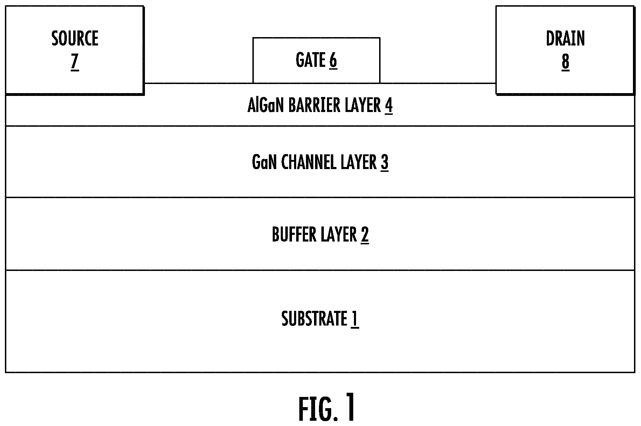

FIG. 1 shows a typical conventional III-Nitride semiconductor transistor which comprises a substrate 1, a buffer layer 2 on top of the substrate, a GaN channel layer 3 on top of the buffer layer and AlGaN barrier layer 4 on top of the channel layer. The substrate 1 is SiC, sapphire, Si or free-standing GaN semiconductors. A nucleation layer exists between the buffer layer 2 and the substrate 1. The AlGaN barrier layer 4 has a wider band-gap than the GaN channel 3. Source electrode 7 and drain electrode 8 are disposed on opposite sides of the gate electrode 6.

This structure has the drawback of relatively high on-resistance for low voltage applications due to the access region resistance and the contact resistance

Thus, it may be beneficial if there were new transistor structures that overcame the drawbacks of the conventional device structure.

### SUMMARY

A new transistor structure for use with III-Nitride semiconductor structures is disclosed. The transistor includes heavily doped n++ layers located in the source region and the drain region. The source and drain electrodes are disposed on their respective heavily doped n++ layer. Further, in some embodiments, a portion of the gate electrode may be disposed on one or both of the heavily doped n++ regions. These regions improve the on-resistance of the transistor, especially for low voltage applications.

According to one embodiment, a semiconductor structure for use in a III-Nitride (III-N) semiconductor device is disclosed. The structure comprises a channel layer; a barrier layer, wherein electrons are formed at an interface between the channel layer and the barrier layer; a source electrode disposed in a source region and a drain electrode disposed in a drain region; a gate electrode disposed between the source electrode and the drain electrode in a gate region; a cap layer disposed between at least a portion of the gate electrode and the barrier layer; and heavily doped n++ layers disposed on either side of the cap layer; wherein the source electrode and the drain electrode each contact at least a portion of a respective heavily doped n++ layer. In some embodiments, the heavily doped n++ layers have a higher n-type doping density than the cap layer. In some embodiments, the heavily doped n++ layers have a n-type doping density of at least 1e18 cm⁻³. In some embodiments, the heavily doped n++ layers have a different n-type doping profile in a vertical direction than the cap layer. In some embodiments, a top surface of the heavily doped n++ layers is flush with a top surface of the cap layer. In some embodiments, a top surface of the heavily doped n++ layers is not flat, and a portion of the top surface adjacent to the cap layer is flush with a top surface of the cap layer. In certain embodiments, the portion has a length of between 0 and 2000 nm. In some embodiments, a portion of the gate electrode is disposed on the heavily doped n++ layer in the source region. In certain embodiments, a portion of the gate electrode is disposed on the heavily doped n++ layer in the drain region. In some embodiments, the heavily doped n++ layers are disposed on top of the barrier layer. In some embodiments, the heavily doped n++ layers are disposed at least partly in the barrier layer. In some embodiments, the heavily doped n++ layers are disposed on top of the channel layer. In some embodiments, the heavily doped n++ layers are disposed at least partly in the channel layer.

According to another embodiment, a semiconductor structure for use in a III-Nitride (III-N) semiconductor device is disclosed. The structure comprises a channel layer; a barrier layer, wherein electrons are formed at an interface between the channel layer and the barrier layer; a source electrode disposed in a source region and a drain electrode disposed in a drain region; a cap layer disposed on top of the barrier layer in a gate region; a gate recess disposed between the source electrode and the drain electrode in the gate region, passing through cap layer; a gate electrode disposed in the gate recess; and heavily doped n++ layers disposed on either side of the cap layer; wherein the source electrode and the drain electrode each contact at least a portion of a respective heavily doped n++ layer. In some embodiments, the gate recess extends to a top surface of the barrier layer. In some embodiments, the gate recess extends through at least a portion of the barrier layer. In some embodiments, a gate dielectric layer is disposed along a bottom and walls of the gate recess and the gate electrode is disposed on the gate dielectric layer. In some embodiments, the gate recess extends through a portion of one or more of the heavily doped n++ layers. In some embodiments, the heavily doped n++ layers have a higher n-type doping density than the cap layer. In some embodiments, the heavily doped n++ layers have a different n-type doping profile in a vertical direction than the cap layer.

### BRIEF DESCRIPTION OF THE FIGURES

For a better understanding of the present disclosure, reference is made to the accompanying drawings, which are incorporated herein by reference and in which:
FIG. 1 shows the layout of a conventional III-Nitride transistor according to the prior art;
FIG. 2 shows an improved III-Nitride transistor that includes heavily doped n++ regions;
FIG. 3 shows a variation of the III-Nitride transistor of FIG. 2;
FIG. 4 shows a variation of the III-Nitride transistor of FIG. 3;
FIG. 5 shows a variation of the III-Nitride transistor of FIG. 3;
FIG. 6 shows a variation of the III-Nitride transistor of FIG. 4; and
FIG. 7 is a flowchart showing the sequence used to fabricate the III-Nitride transistor shown in any of the figures.

### DETAILED DESCRIPTION

This disclosure describes a III-Nitride transistor device with lower on-resistance.

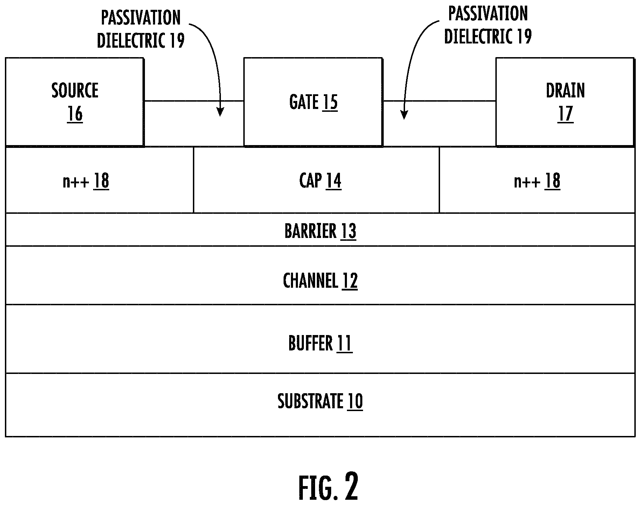

Referring to FIG. 2, the transistor structure includes a substrate 10, a buffer layer 11, a channel layer 12, a barrier layer 13, and a cap layer 14. In many embodiments, a nucleation layer may be disposed between the substrate 10 and the buffer layer 11.

The substrate 10 may be SiC, sapphire, Si, free-standing GaN or any other substrate including multiple layers including polycrystalline AlN. A nucleation layer may be disposed between the buffer layer 11 and surface of the substrate 10. The nucleation layer may include AlN.

A buffer layer 11 is formed over the nucleation layer. The buffer layer 11 may have a thickness between 0.5 nm and several microns, although other thicknesses are within the scope of the disclosure. The buffer layer 11 may comprise III-nitride semiconductors including GaN, AlGaN, InGaN, InAlN, InAlGaN and AlN.

A channel layer 12 is formed over the buffer layer 11. The channel layer 12 comprises a semiconductor material selected from AlGaN, InGaN, GaN, or any other suitable semiconductor material or combination of materials.

Carriers, which may be free electrons, exist in the channel layer 12 to conduct electrical current between the drain contact and the source contact.

The channel layer 12 may comprise a single layer such as a GaN layer, or multiple layers. In one example, the channel layer 12 comprises a back-barrier structure, such as a GaN layer over an AlGaN layer (GaN/AlGaN) or a GaN layer over an InGaN layer and another GaN layer (GaN/InGaN/GaN). In another example, the channel layer 12 has a superlattice structure formed by repeating a bilayer structure of AlGaN/GaN or AlN/GaN. The thickness of the channel layer 12 may be greater than 5 nm, such as between 50 nm and 400 nm, although other thicknesses may be used.

A barrier layer 13 is formed over the channel layer 12. The barrier layer 13 may be made of III-nitride semiconductors selected from AlGaN, InAlN, AlN, AlScN or InAlGaN with a non-zero aluminum content. The barrier layer 13 may be un-doped, or doped with Si or other impurities. The barrier layer 13 has a wider band-gap than the channel layer 12. The barrier layer 13 may be between 0.2 nm and 30 nm. A thin barrier layer, such as less than 10 nm, may be utilized. The barrier layer 13 may contain sub-layers. For example, a sub-layer of AlN may be adjacent to the channel layer 12 and a AlGaN or InAlN sublayer may be disposed on top of the AlN sublayer.

The cap layer 14 comprises III-nitride semiconductors, such as GaN, AlN, AlGaN or a combination of these. The cap layer 14 may be n-type doped, or may be undoped. In some embodiments, the cap layer 14 may have a thin delta-doping layer. The cap layer 14 may also have different doping levels in the vertical direction. The cap layer 14 may also include sub-layers. For example, the bottom of the cap layer 14 may have a sub-layer made of AlN or AlGaN as an etch-stop layer and the top of the cap layer 14 may have a sub-layer made of GaN disposed on top of the bottom of the cap layer. The thickness of the cap layer 14 may be less than 200 nm, such as between 0.5-50 nm.

The top of the device structure includes a gate electrode 15, a source electrode 16 and a drain electrode 17.

In opposite sides of the gate, a heavily n-type doped (n++) layer 18 is formed on top of the barrier layer 13. One such heavily doped n++ layer is referred to as the source region and the other heavily doped n++ layer is referred to as the drain region. This heavily doped n++ layer 18 may be different from the cap layer 14 in composition or may be the same. Further, the heavily doped n++ layer differs from the cap layer 14 in terms of doping profile. The heavily doped n++ layer 18 has an n-type doping density higher than 1e18 cm⁻³. In some embodiments, the heavily doped n++ layer 18 may have an n-type doping density of 1e20 cm⁻³ or higher. The cap layer 14 may have a lower doping density or a different doping profile in the vertical (or height) direction. The n-type dopant may be Si. The heavily doped n++ layer 18 is made from III-nitride semiconductors, such as GaN, InGaN, AlGaN. The heavily doped n++ layer 18 may not have the same sub-layers as in the cap layer 14. For example, the etch-stop sub-layer in the cap layer 14 may be absent from the heavily doped n++ layer 18. The heavily doped n++ layer 18 may be formed through epitaxy growth such as molecular beam epitaxy (MBE) or metalorganic chemical vapor deposition (MOCVD). The heavily doped n++ layer 18 may also be formed through ion implantation.

Source electrode 16 and drain electrode 17 are deposited over the heavily doped n++ layer 18 in the source region and drain region, respectively. The source electrode 16 and drain electrode 17 each contact at least a portion of the heavily doped n++ layer 18 in the source region and drain region, respectively. The source electrode 16 and drain electrode 17 may be made of Ti, TiN, Al, W, Au or other suitable materials and/or a combination of the materials that form ohmic contact to the heavily doped n++ layer 18. The gate electrode 15 is deposited over the cap layer 14. The gate electrode 15 may be made of materials such as Ni, Ti, TiN, W, WN, Pt, Al, Au, polysilicon and any other suitable conductive material and their combinations.

A passivation dielectric material 19 may be deposited on top of the exposed portions of the cap layer 14 and the heavily doped n++ layer 18. This passivation dielectric material 19 may be made of a dielectric material such as SiO₂, SiₓN_{y}, SiOₓN_{y}, Al₂O₃, HfO₂ and any other suitable dielectric material.

FIG. 2 shows that the top of the heavily doped n++ layers 18 and the top of the cap layer 14 are aligned at the same height at their joint boundaries, such that the top surface of the heavily doped n++ layers 18 are flush with the top surface of the cap layer 14. FIG. 2 also shows that the top surface of the heavily doped n++ layers 18 is flat. However, other embodiments are also possible.

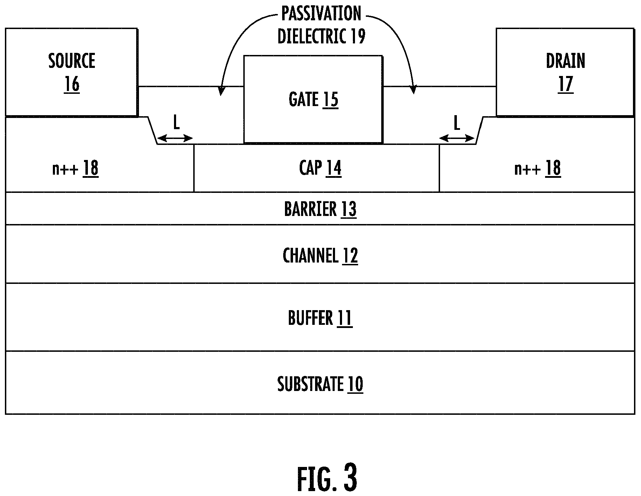

FIG. 3 shows an example where the heavily doped n++ layer 18 has non-flat surfaces in the source and drain regions. The difference in the height of the heavily doped n++ layer 18 may be several hundred nanometers. At the boundary between the heavily doped n++ layer 18 and the cap layer 14, a portion of the heavily doped n++ layer 18 with a length of L has the same height and is flush with the top surface of the cap layer 14. The length L can range from 0nm to more than 2000nm. The other components in FIG. 3 are as described with respect to FIG. 2.

Note that in FIG. 2 and FIG. 3, the gate electrode 15 does not overlap with the heavily doped n++ layer 18. However, other embodiments are also possible.

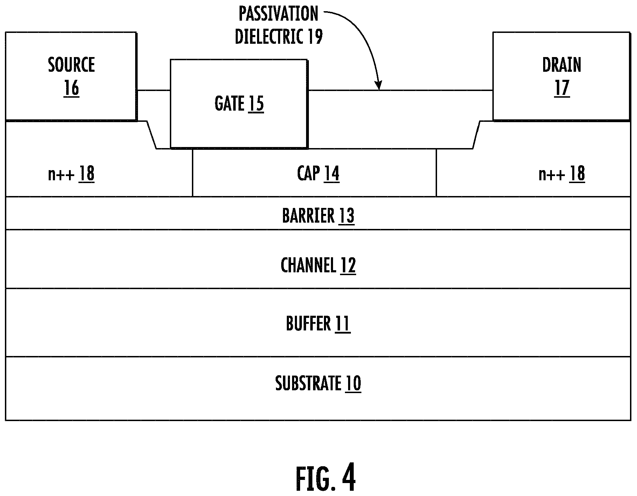

In another embodiment, shown in FIG. 4, the gate electrode 15 is formed over a portion of the top surface of the cap layer 14 and has an overlap with the heavily doped n++ layer 18 in the source region. In another embodiment (not shown), the gate electrode 15 may overlap with the heavily doped n++ layer 18 in both source region and the drain region. The gate electrode 15 may make Schottky contact to the cap layer 14 or there may be a gate dielectric material disposed between the gate electrode 15 and the cap layer 14 and heavily doped n++ layer 18 below. The other components in FIG. 4 are as described with respect to FIG. 2.

In the previous embodiments, the heavily doped n++ layer 18 is disposed on top of the barrier layer 13. However, other embodiments are also possible.

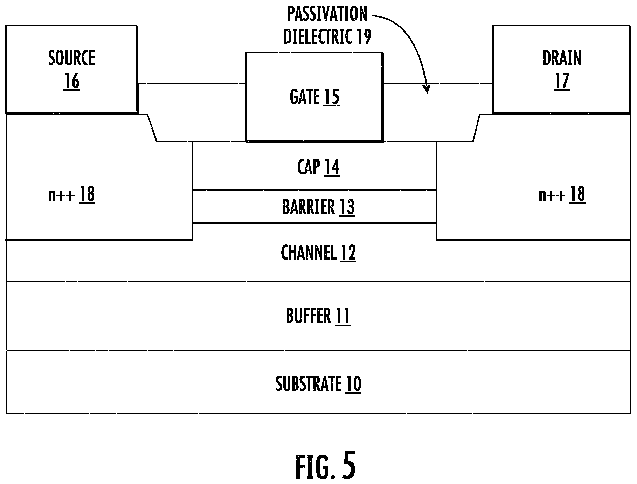

As shown in FIG. 5, the heavily doped n++ layer 18 may extend through the barrier layer 13 and into the channel layer 12. In another embodiment (not shown), the heavily doped n++ regions may extend into the barrier layer 13, but not into the channel layer 12. In another embodiment (not shown), the heavily doped n++ regions may extend through the barrier layer 13 and be disposed on the top of the channel layer 12. The other components in FIG. 5 are as described with respect to FIG. 2.

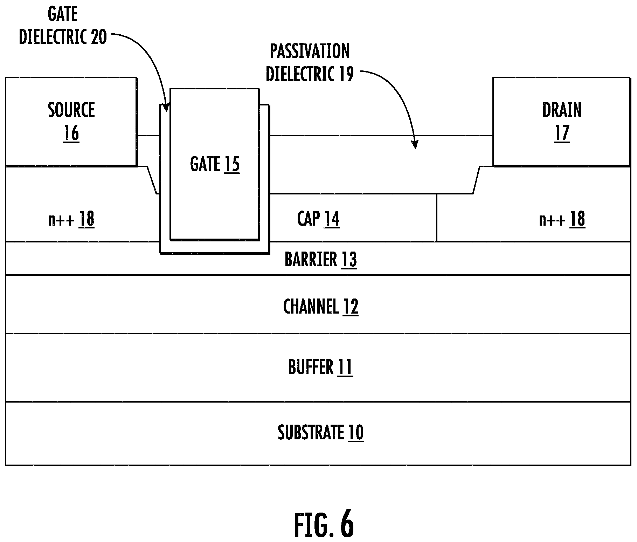

FIG. 6 shows another embodiment where a gate recess is formed in the gate region through the cap layer 14 and a portion of the heavily doped n++ layer 18 in the source region. It is also possible that the gate recess can etch through a portion of the heavily doped n++ layer 18 in both the source region and the drain region. The bottom of the gate recess may be at the top surface of the barrier layer 13 as shown in FIG. 6, or inside the barrier layer 13 or in the channel layer 12. A gate dielectric layer 20 is formed in the gate recess and a gate electrode 15 is formed over the gate dielectric layer 20. The gate dielectric layer 20 may be along the bottom and sides of the gate recess. The gate dielectric layer 20 may be made of dielectric materials such as SiₓN_{y}, SiO₂, SiₓO_{y}N_{z}, Al₂O₃, AlN, AlOxNy or any other suitable dielectric material or a combination of them. The other components in FIG. 6 are as described with respect to FIG. 2.

Note that these are not the only embodiments. For example, the flat heavily doped n++ layers 18 shown in FIG. 2 may be used with any of the embodiments in FIGs. 4-6. The deeper heavily doped n++ layers 18 shown in FIG. 5 may also be used with the offset gate electrode 15 shown in FIG. 4, or with the gate dielectric layer 20 shown in FIG. 6. The gate recess and gate dielectric layer 20 shown in FIG. 6 may be used with any of the embodiments in FIGs. 2-5.

Each of the transistors shown in FIGs. 2-6 may be either normally-on transistors with electrons in the channel layer 12 underneath the gate electrode 15 connecting the source and drain when the gate electrode 15 is not biased, or normally-off transistors with the electrons absent from the channel layer 12 underneath the gate when the gate electrode 15 is not biased.

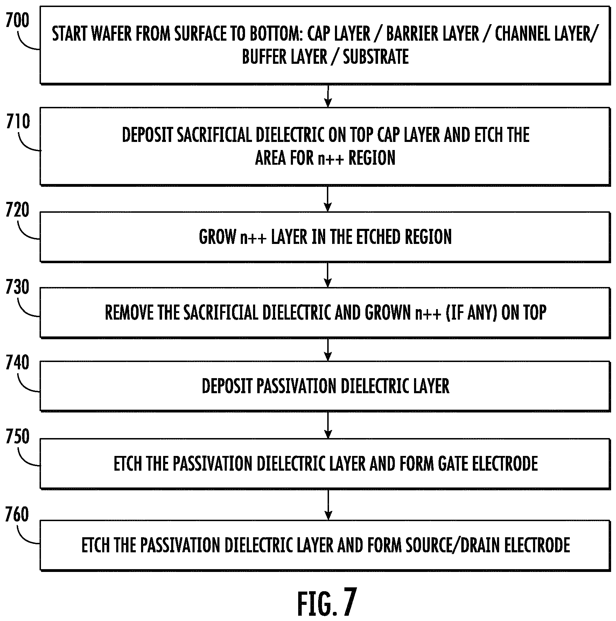

FIG. 7 shows a fabrication sequence that may be used to create the device structure of FIG. 2. First, as shown in Box 700, the buffer layer 11, channel layer 12, the barrier layer 13 and the cap layer 14 are deposited on the substrate 10. Then, as shown in Box 710, a sacrificial dielectric layer is deposited on top of the cap layer 14. The areas where the heavily doped n++ layer 18 will be formed are then etched. The etching extends through at least the sacrificial layer and the cap layer 14. In some embodiments, the etching extends into the barrier layer 13 and optionally the channel layer 12. Next, as shown in Box 720, the heavily doped n++ layer 18 is grown in the etched areas. This may be done using MBE or MOCVD.

Next, as shown in Box 730, the sacrificial dielectric layer and any n++ layer that grew on this sacrificial layer are removed. As shown in Box 740, a passivation dielectric material 19 may then be deposited on the top surface of the structure. As shown in Box 750, the passivation dielectric material 19 is then etched to form the opening for the gate electrode 15. The gate electrode 15 is then formed in this opening. Finally, as shown in Box 760, the passivation dielectric material is etched to form the openings for the source electrode 16 and the drain electrode 17. These electrodes are then formed in these openings.

There are variations of this fabrication sequence. For example, the order in which the gate electrode 15 and the source and drain electrodes are formed may be changed. Further, additional process steps, which are not shown here, include depositing additional dielectric layers, forming of field plates and interconnections.

Further, additional passivation dielectric and field plate structures may be applied to the transistors shown in FIGs. 2-6. Additionally, the gate electrode 15, source electrode 16 and drain electrode 17 may have an overhang or a sloped sidewall other than the rectangular shape shown in FIGs. 2-6.

The system described herein have many advantages. The use of the heavily doped n++ layers 18 decreases the on-resistance, even in low voltage applications. Additionally, the shape of the heavily doped n++ region reduces transistor source resistance and parasitic capacitances.

The present disclosure is not to be limited in scope by the specific embodiments described herein. Indeed, other various embodiments of and modifications to the present disclosure, in addition to those described herein, will be apparent to those of ordinary skill in the art from the foregoing description and accompanying drawings. Thus, such other embodiments and modifications are intended to fall within the scope of the present disclosure. Furthermore, although the present disclosure has been described herein in the context of a particular implementation in a particular environment for a particular purpose, those of ordinary skill in the art will recognize that its usefulness is not limited thereto and that the present disclosure may be beneficially implemented in any number of environments for any number of purposes. Accordingly, the claims set forth below should be construed in view of the full breadth and spirit of the present disclosure as described herein.

## Claims

1. A semiconductor structure for use in a III-Nitride (III-N) semiconductor device, comprising:
a channel layer;
a barrier layer, wherein electrons are formed at an interface between the channel layer and the barrier layer;
a source electrode disposed in a source region and a drain electrode disposed in a drain region;
a gate electrode disposed between the source electrode and the drain electrode in a gate region;
a cap layer disposed between at least a portion of the gate electrode and the barrier layer; and
heavily doped n++ layers disposed on either side of the cap layer;
wherein the source electrode and the drain electrode each contact at least a portion of a respective heavily doped n++ layer.

2. The semiconductor structure of claim 1, wherein the heavily doped n++ layers have a higher n-type doping density than the cap layer.

3. The semiconductor structure of claim 1, wherein the heavily doped n++ layers have a n-type doping density of at least 1e18 cm⁻³.

4. The semiconductor structure of claim 1, wherein the heavily doped n++ layers have a different n-type doping profile in a vertical direction than the cap layer.

5. The semiconductor structure of claim 1, wherein a top surface of the heavily doped n++ layers is flush with a top surface of the cap layer.

6. The semiconductor structure of claim 1, wherein a top surface of the heavily doped n++ layers is not flat, and a portion of the top surface adjacent to the cap layer is flush with a top surface of the cap layer.

7. The semiconductor structure of claim 6, wherein the portion has a length of between 0 and 2000 nm.

8. The semiconductor structure of claim 1, wherein a portion of the gate electrode is disposed on the heavily doped n++ layer in the source region.

9. The semiconductor structure of claim 8, wherein a portion of the gate electrode is disposed on the heavily doped n++ layer in the drain region.

10. The semiconductor structure of claim 1, wherein the heavily doped n++ layers are disposed on top of the barrier layer.

11. The semiconductor structure of claim 1, wherein the heavily doped n++ layers are disposed at least partly in the barrier layer.

12. The semiconductor structure of claim 1, wherein the heavily doped n++ layers are disposed on top of the channel layer.

13. The semiconductor structure of claim 1, wherein the heavily doped n++ layers are disposed at least partly in the channel layer.

14. A semiconductor structure for use in a III-Nitride (III-N) semiconductor device, comprising:
a channel layer;
a barrier layer, wherein electrons are formed at an interface between the channel layer and the barrier layer;
a source electrode disposed in a source region and a drain electrode disposed in a drain region;
a cap layer disposed on top of the barrier layer in a gate region;
a gate recess disposed between the source electrode and the drain electrode in the gate region, passing through cap layer;
a gate electrode disposed in the gate recess; and
heavily doped n++ layers disposed on either side of the cap layer;
wherein the source electrode and the drain electrode each contact at least a portion of a respective heavily doped n++ layer.

15. The semiconductor structure of claim 14, wherein the gate recess extends to a top surface of the barrier layer.

16. The semiconductor structure of claim 14, wherein the gate recess extends through at least a portion of the barrier layer.

17. The semiconductor structure of claim 14, wherein a gate dielectric layer is disposed along a bottom and walls of the gate recess and the gate electrode is disposed on the gate dielectric layer.

18. The semiconductor structure of claim 14, wherein the gate recess extends through a portion of one or more of the heavily doped n++ layers.

19. The semiconductor structure of claim 14, wherein the heavily doped n++ layers have a higher n-type doping density than the cap layer.

20. The semiconductor structure of claim 14, wherein the heavily doped n++ layers have a different n-type doping profile in a vertical direction than the cap layer.
